# EUROPEAN PATENT APPLICATION

(11) **EP 4 848 958 A1**
(43) Date of publication of application: **02.12.2026**
(21) Application number: 24930002.1
(22) Date of filing: 18.03.2024
(51) Int. Cl.: H10K 59/122, H10K 59/30

(54) **DISPLAY SUBSTRATE AND DISPLAY DEVICE**

(71) Applicant: Boe Technology Group Co., Ltd., Beijing 100015 (CN)
(72) Inventor: LIU, Yang, Beijing 100176 (CN); CHEN, Lei, Beijing 100176 (CN); WANG, Dan, Beijing 100176 (CN); FAN, Cong, Beijing 100176 (CN); WANG, Hongli, Beijing 100176 (CN)
(74) Representative: Brötz, Helmut
(86) International application number: PCT/CN2024/082280
(87) International publication number: WO 2025/194313

(57) **Abstract**

At least one embodiment of the present disclosure provides a display substrate and a display device. The display substrate comprises : a base substrate; a pixel defining layer comprising a plurality of pixel openings and pixel spacing parts; a plurality of sub-pixels having one-to-one correspondence with the plurality of pixel openings, each sub-pixel comprising a light-emitting element, the light-emitting element comprising a light-emitting functional layer, a second electrode and a first electrode, and the first electrode being located between the light-emitting functional layer and the base substrate; and partition structures located between adjacent sub-pixels and located on the side of the pixel spacing parts away from the base substrate. Each light-emitting functional layer comprises a first organic light-emitting functional layer, a first charge generation layer, a second organic light-emitting functional layer, a second charge generation layer, and a third organic light-emitting functional layer which are at least partially stacked on the pixel spacing parts on a main surface perpendicular to the base substrate, and the distance from the surface, farthest from the pixel defining layer, of the portion of the second charge generation layer located on the pixel spacing parts to the pixel defining layer is less than the height of the partition structures.

## Description

### TECHNICAL FIELD

Embodiments of the present disclosure relate to a display substrate and a display device.

### BACKGROUND

With the continuous development of display technology, the organic light emitting diode display device (OLED) has become the research focus and technology development direction of major manufacturers because of its advantages such as wide color gamut, high contrast, light and thin design, self-luminescence and wide viewing angle.

At present, Organic light emitting diode display devices (OLED) have been widely used in various electronic products, ranging from smart bracelets, smart watches, smart phones, tablets and other electronic products with mall sizes to notebook computers, desktop computers, televisions and other electronic products with large sizes. Therefore, the market demand for active matrix organic light emitting diode display devices is also growing.

### SUMMARY

At least one embodiment of the present disclosure provides a display substrate and a display device. In the display substrate, the light emitting functional layer comprises a first organic light emitting functional layer, a first charge generation layer, a second organic light emitting functional layer, a second charge generation layer and a third organic light emitting functional layer which are at least partially stacked on the pixel spacing portion in a direction perpendicular to the main surface of the base substrate, and a distance between a surface, which is farthest from the pixel defining layer, of a portion of the second charge generation layer located on the pixel spacing portion and the pixel defining layer is smaller than a height of the partition structure in the direction perpendicular to the main surface of the base substrate, so that the partition structure can at least separate the first charge generation layer and the second charge generation layer corresponding to different sub-pixels to prevent the lateral drift of charges between adjacent sub-pixels, thus avoiding the crosstalk between adjacent sub-pixels caused by the charge generation layers with higher conductivity, and further the display problem of crosstalk between sub-pixels which is easy to occur in the display substrate with a stacked structure can be removed.

At least one embodiment of the present disclosure provides a display substrate, and the display substrate includes a base substrate; a pixel defining layer, located on the base substrate and including a plurality of pixel openings and a pixel spacing portion; a plurality of sub-pixels, located on the base substrate and arranged in one-to-one correspondence with the plurality of pixel openings, in which each of the plurality of sub-pixels comprises a light emitting element, the light emitting element comprises a light emitting functional layer and a second electrode and a first electrode located on two sides of the light emitting functional layer in a direction perpendicular to a main surface of the base substrate, and the first electrode is located between the light emitting functional layer and the base substrate; and a partition structure, located between adjacent sub-pixels of the plurality of sub-pixels and at a side of the pixel spacing portion away from the base substrate, in which the light emitting functional layer comprises a first organic light emitting functional layer, a first charge generation layer, a second organic light emitting functional layer, a second charge generation layer and a third organic light emitting functional layer which are at least partially stacked on the pixel spacing portion in the direction perpendicular to the main surface of the base substrate, and a distance between a surface, which is farthest from the pixel defining layer, of a portion of the second charge generation layer located on the pixel spacing portion and the pixel defining layer is smaller than a height of the partition structure in the direction perpendicular to the main surface of the base substrate.

For example, in the display substrate provided by at least one embodiment of the present disclosure, the second charge generation layer comprises a second electron generation sub-layer and a second hole generation sub-layer which are stacked, and a distance between a surface, which is farthest from the pixel defining layer, of a portion of the second hole generation sub-layer and the pixel defining layer is smaller than the height of the partition structure in the direction perpendicular to the main surface of the base substrate.

For example, in the display substrate provided by at least one embodiment of the present disclosure, the distance between the surface, which is farthest from the pixel defining layer, of the portion of the second hole generation sub-layer and the pixel defining layer is L1, the height of the partition structure in the direction perpendicular to the main surface of the base substrate is L2, L1 is greater than or equal to 0.12µm and less than or equal to 0.14µm, and L2 is greater than or equal to 0.42µm and less than or equal to 1.45µm.

For example, in the display substrate provided by at least one embodiment of the present disclosure, the first organic light emitting functional layer comprises a hole injection layer, a first hole transport layer, a first electron blocking layer, a first organic light emitting layer, a first hole blocking layer and a first electron transport layer which are stacked; the first charge generation layer comprises a first electron generation sub-layer and a first hole generation sub-layer which are stacked; the second organic light emitting functional layer comprises a second hole transport layer, a second electron blocking layer, a second organic light emitting layer, a second hole blocking layer and a second electron transport layer; the third organic light emitting functional layer comprises a third hole transport layer, a third electron blocking layer, a third organic light emitting layer, a third hole blocking layer and a third electron transport layer which are stacked; the hole injection layer, the first hole transport layer and the first electron blocking layer constitute a first organic functional layer; the first hole blocking layer, the first electron transport layer, the first electron generation sub-layer, the first hole generation sub-layer, the second hole transport layer and the second electron blocking layer constitute a second organic functional layer; the second hole blocking layer, the second electron transport layer, the second electron generation sub-layer, the second hole generation sub-layer, the third electron blocking layer and the third electron transport layer constitute a third organic functional layer; the third hole blocking layer and the third electron transport layer constitute a fourth organic functional layer.

For example, in the display substrate provided by at least one embodiment of the present disclosure, a relationship between a thickness L3 of the second organic functional layer and a thickness L4 of the first organic functional layer is: L3 > L4.

For example, in the display substrate provided by at least one embodiment of the present disclosure, a relationship between a thickness L5 of the third organic functional layer and a thickness L6 of the fourth organic functional layer is: L5 > L6.

For example, in the display substrate provided by at least one embodiment of the present disclosure, the thickness L3 of the second organic functional layer is less than or equal to the thickness L5 of the third organic functional layer.

For example, in the display substrate provided by at least one embodiment of the present disclosure, the sub-pixel is a red sub-pixel, and a thickness of the first organic light emitting layer, a thickness of the second organic light emitting layer, and a thickness of the third organic light emitting layer in the red sub-pixel are all greater than a thickness of a thickest one of sub-layers in the first organic functional layer, and are all greater than a thickness of a thickest one of sub-layers in the third organic functional layer.

For example, in the display substrate provided by at least one embodiment of the present disclosure, the sub-pixel is a blue sub-pixel, and a thickness of the first organic light emitting layer, a thickness of the second organic light emitting layer, and a thickness of the third organic light emitting layer in the blue sub-pixel are all smaller than a thickness of a thickest one of sub-layers in the first organic functional layer, and are all smaller than a thickness of a thickest one of sub-layers in the third organic functional layer.

For example, in the display substrate provided by at least one embodiment of the present disclosure, the plurality of pixel openings respectively define effective light emitting regions of the plurality of sub-pixels, and each of the plurality of pixel openings is configured to expose the first electrode.

At least one embodiment of the present disclosure further provides a display device, and the display device includes any one of the display substrates in the above embodiments.

### BRIEF DESCRIPTION OF DRAWINGS

In order to explain the technical solution of the embodiments of the present disclosure more clearly, the attached drawings of the embodiments will be briefly introduced below. Obviously, the attached drawings in the following description only relate to some embodiments of the present disclosure, and are not limited to the present disclosure.
Fig. 1 is a schematic cross-sectional view of a display substrate provided by at least one embodiment of the present disclosure;
Fig. 2 is a schematic cross-sectional view of a partial layer structure of a light emitting functional layer, a pixel defining layer and a partition structure in Fig. 1;
Fig. 3 is a schematic cross-sectional view of another display substrate provided by at least one embodiment of the present disclosure;
Fig. 4 is a schematic cross-sectional view of a partial layer structure of a light emitting functional layer, a pixel defining layer and a partition structure in Fig. 3;
Fig. 5 is a schematic cross-sectional view of another display substrate provided by at least one embodiment of the present disclosure;
Fig. 6 is a schematic cross-sectional view of a partial layer structure of a light emitting functional layer, a pixel defining layer and a partition structure in Fig. 5;
Fig. 7 is a schematic cross-sectional view of each layer structure of the display substrate provided by at least one embodiment of the present disclosure; and
Fig. 8 is a schematic diagram of a display device provided by at least one embodiment of the present disclosure.

### DETAILED DESCRIPTION

In order to make the purpose, technical solution and advantages of the embodiments of the present disclosure clear, the technical solution of the embodiment of the present disclosure will be described clearly and completely with the accompanying drawings of specific embodiments of the present disclosure. It should be noted that the described embodiment is a part of the embodiment of the present disclosure, not the whole embodiment. Based on the described embodiments of the present disclosure, all other embodiments obtained by ordinary people in the field without creative labor belong to the scope of protection of the present disclosure.

Unless otherwise defined, technical terms or scientific terms used in the present disclosure shall have their ordinary meanings as understood by people with ordinary skills in the field to which the present disclosure belongs. The terms "first", "second" and the like used in the present disclosure do not indicate any order, quantity or importance, but are only used to distinguish different components. Similar words such as "including" or "containing" refer to that the elements or objects appearing before the word cover the elements or objects listed after the word and their equivalents, without excluding other elements or objects. Similar words such as "connected" or "connected" are not limited to physical or mechanical connection, but can include electrical connection, whether direct or indirect. "Up", "Down", "Left" and "Right" are only used to indicate the relative positional relationship. When the absolute position of the described object changes, the relative positional relationship may also change accordingly.

Unless otherwise defined, the features such as "parallel", "vertical" and "identical" used in the embodiments of the present disclosure all include cases such as "parallel", "vertical" and "identical" in a strict sense, and cases such as "approximately parallel", "approximately vertical" and "approximately identical" contain certain errors. For example, the above-mentioned "roughly" can refer to that the difference of the compared objects is within 10% or 5% of the average value of the compared objects. When the number of one component or element is not specified in the following of the embodiment of the present disclosure, it refers to that the component or element can be one or more, or can be understood as at least one. "At least one" refers to one or more, and "a plurality of" refers to at least two. "Arranged in the same layer" in the embodiment of the present disclosure refers to the relationship between a plurality of film layers formed by the same material after the same step (for example, one-step patterning process). The "same layer" here does not always mean that the thicknesses of the plurality of film layers are the same or the heights of the plurality of film layers in cross section are the same.

At present, the mass-produced stacked organic light emitting diode display device is a structure in which two light emitting layers are stacked, but in order to further improve the display efficiency of the organic light emitting diode display device and prolong the service life of the organic light emitting diode display device, the inventor(s) of the present disclosure has noticed that the structure in which two light emitting layers are stacked can be replaced by the structure in which three light emitting layers are stacked, and the light emitting layers are separated by an organic layer. In this way, the ultra-high display efficiency and the ultra-long service life of the organic light emitting diode display device can be realized, and the inventor(s) of the present disclosure also noticed that the light extraction efficiency of the micro-cavity structure can be enhanced by defining the thickness relationship among the various layer structures of the organic light emitting diode display device; moreover, the inventor(s) of the present disclosure has also noticed that the three light emitting layers which are stacked are separated by two groups of charge generation layers, each group of charge generation layers includes a hole charge generation layer and an electron charge generation layer, which easily leads to lateral drift between adjacent pixels, and the stacked organic light emitting diode display device is prone to generate crosstalk between pixels, thus causing display problems. A partition structure is arranged on the pixel defining layer of the organic light emitting diode display device, and the distance relationship between the height of the partition structure and the surface, which is farthest from the pixel defining layer, of a portion of the second charge generation layer on the pixel spacing portion is defined, the second charge generation layer corresponding to different sub-pixels is separated by the partition structure, so as to prevent the lateral drift between adjacent sub-pixels, thereby the display problem of crosstalk between sub-pixels which is easy to occur in the display substrate with a stacked structure can be removed.

At least one embodiment of the present disclosure provides a display substrate, the display substrate includes a base substrate; a pixel defining layer, located on the base substrate and including a plurality of pixel openings and a pixel spacing portion; a plurality of sub-pixels, located on the base substrate and arranged in one-to-one correspondence with the plurality of pixel openings, each of the plurality of sub-pixels includes a light emitting element, the light emitting element includes a light emitting functional layer and a second electrode and a first electrode located on both sides of the light emitting functional layer in a direction perpendicular to a main surface of the base substrate, and the first electrode is located between the light emitting functional layer and the base substrate; the display substrate further includes a partition structure, located between adjacent sub-pixels of the plurality of sub-pixels and at a side of the pixel spacing portion away from the base substrate, the light emitting functional layer includes a first organic light emitting functional layer, a first charge generation layer, a second organic light emitting functional layer, a second charge generation layer and a third organic light emitting functional layer which are at least partially stacked on the pixel spacing portion in the direction perpendicular to the main surface of the base substrate, and a distance between a surface, which is farthest from the pixel defining layer, of a portion of the second charge generation layer located on the pixel spacing portion and the pixel defining layer is smaller than a height of the partition structure in the direction perpendicular to the main surface of the base substrate.

For example, in the display substrate provided by the embodiment of the present disclosure, the light emitting functional layer includes a first organic light emitting functional layer, a first charge generation layer, a second organic light emitting functional layer, a second charge generation layer and a third organic light emitting functional layer which are at least partially stacked on the pixel spacing portion in the direction perpendicular to the main surface of the base substrate, the distance between the surface, which is farthest from the pixel defining layer, of the portion of the second charge generation layer located on the pixel spacing portion and the pixel defining layer is smaller than the height of the partition structure in the direction perpendicular to the main surface of the base substrate, so that the partition structure can at least separate the first charge generation layer and the second charge generation layer corresponding to different sub-pixels, so as to prevent the lateral drift of charges between adjacent sub-pixels, thereby avoiding the crosstalk between adjacent sub-pixels caused by the charge generation layers with higher conductivity, and further the display problem of crosstalk between sub-pixels which is easy to occur in the display substrate with a stacked structure can be removed.

The display substrate provided by the embodiment of the present disclosure includes three light emitting layers which are stacked, and adjacent light emitting layers are separated by an organic layer. The display substrate provided by the embodiment of the present disclosure can achieve ultra-high efficiency and ultra-long service life of organic light emitting display device. The display substrate provided by the embodiment of the present disclosure also enhances the light extraction efficiency of the microcavity structure by defining the thickness relationship among the various layer structures in the display substrate, moreover, the display substrate provided by the embodiment of the present disclosure also makes the distance between a surface, which is farthest from the pixel defining layer, of a portion of the second charge generation layer located on the pixel spacing portion and the pixel defining layer be smaller than the height of the partition structure in the direction perpendicular to the main surface of the base substrate, so that the partition structure at least separates the first charge generation layer and the second charge generation layer corresponding to different sub-pixels to prevent the lateral drift of charges between adjacent sub-pixels. Therefore, the crosstalk between adjacent sub-pixels caused by the charge generation layer with higher conductivity can be further avoided, and the display problem of crosstalk between sub-pixels which is easy to occur in the display substrate with a stacked structure can be removed.

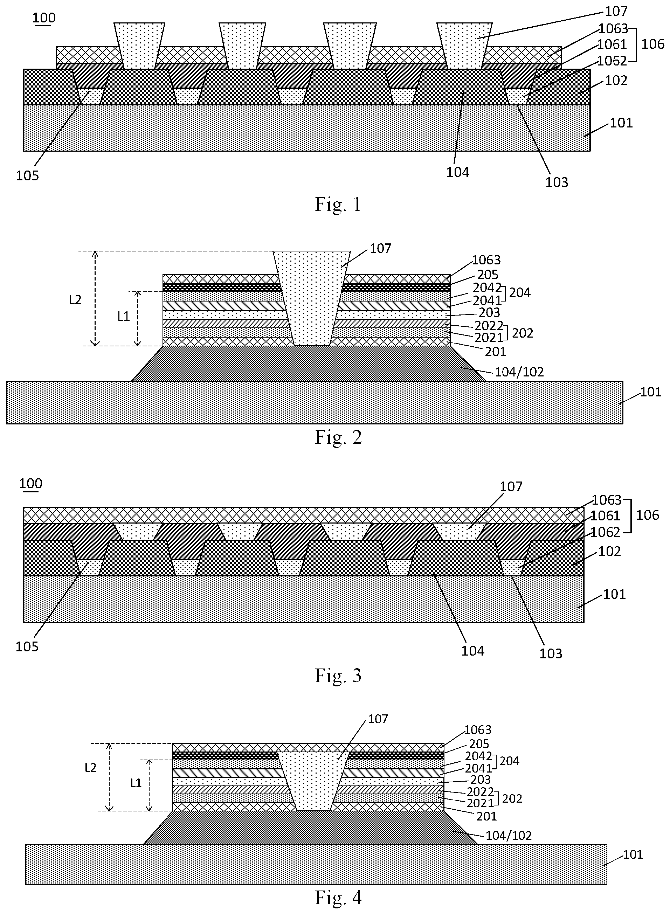

For example, Fig. 1 is a schematic cross-sectional structure diagram of a display substrate provided by at least one embodiment of the present disclosure. As illustrated by Fig. 1, the display substrate 100 includes a base substrate 101; a pixel defining layer 102 is arranged on the base substrate 101, and the pixel defining layer 102 includes a plurality of pixel openings 103 and a pixel spacing portion 104. There are a plurality of sub-pixels 105 on the base substrate 101, the plurality of sub-pixels 105 are arranged in one-to-one correspondence with the plurality of pixel openings 103. Each of the plurality of sub-pixels 105 includes a light emitting element 106, the light emitting element 106 includes a light emitting functional layer 1061, and a second electrode 1063 and a first electrode 1062 located at two sides of the light emitting functional layer 1061 in a direction perpendicular to the main surface of the base substrate 101. The first electrode 1062 is located between the light emitting functional layer 1061 and the base substrate 101. For example, the display substrate 100 is an organic light emitting diode display substrate, and when the organic light emitting diode display substrate is used in a display panel, adjacent sub-pixels 105 display different colors.

For example, in one example, the first electrode 1062 is an anode and the second electrode 1063 is a cathode. The cathode can be made of a material with high conductivity and low work function, for example, the cathode can be made of a metal material. For example, the anode may be formed of a transparent conductive material with a high work function.

For example, as illustrated by Fig. 1, the display substrate 100 further includes a partition structure 107 located between adjacent sub-pixels 105, and the partition structure 107 is located at a side of the pixel spacing portion 104 away from the base substrate 101. For example, in the structure shown in Fig. 1, a surface of the partition structure 107 farthest from the base substrate 101 is higher than a surface of the second electrode 1063 farthest from the base substrate 101, so that the partition structure 107 can completely separate the light emitting structures corresponding to different sub-pixels.

For example, because the display substrate 100 can avoid crosstalk between adjacent sub-pixels through the partition structure 107, the display substrate can improve the pixels per inch while adopting a double-layer light emitting design, thus making the display substrate have the advantages of long life, low power consumption, high brightness and high resolution.

For example, as illustrated by Fig. 1, a shape of a first section of the partition structure 107 cut along an arrangement direction of adjacent sub-pixels 105 and perpendicular to a plane of the base substrate 101 is an inverted trapezoid, that is, the length of the bottom edge of the inverted trapezoid away from the base substrate 101 is longer than the length of the bottom edge of the inverted trapezoid close to the base substrate 101. For example, an included angle between a lateral edge of the inverted trapezoid and the bottom edge of the inverted trapezoid close to the base substrate 101 is not less than 95 degrees, for example, the included angle between the lateral edge of the inverted trapezoid and the bottom edge of the inverted trapezoid away from the base substrate 101 is not more than 85 degrees. This angle design can make the included angle between the lateral edge of the partition structure 107 and the bottom edge of the inverted trapezoid away from the base substrate 101 be an acute angle, thus facilitating the subsequent formation of the light emitting functional layer to be disconnected at the edge of the partition structure 107. Of course, the cross-sectional shape of the partition structure 107 in the display substrate provided by the embodiment of the present disclosure is not limited to the above-mentioned inverted trapezoid, but also can be rectangular or regular trapezoid, and the embodiment of the present disclosure is not limited thereto.

For example, Fig. 2 is a schematic cross-sectional view of a partial layer structure of a light emitting functional layer, a pixel defining layer and a partition structure in Fig. 1. For example, as illustrated by combination with Fig. 1 and Fig. 2, the light emitting functional layer 1061 includes a first organic light emitting functional layer 201, a first charge generation layer 202, a second organic light emitting functional layer 203, a second charge generation layer 204 and a third organic light emitting functional layer 205 which are at least partially stacked on the pixel spacing portion 104 in the direction perpendicular to the main surface of the base substrate 101, and a surface, which is farthest from the pixel defining layer 102, of a portion of the second charge generation layer 204 located on the pixel spacing portion 104 and the pixel defining layer 105 is smaller than a height of the partition structure 107 in the direction perpendicular to the main surface of the base substrate 101. For example, in the structure shown in Fig. 2, the distance between the surface, which is farthest from the pixel defining layer 102, of the portion of the second charge generation layer 204 located on the pixel spacing portion 104 and the pixel defining layer 102 is L1, the height of the partition structure 107 in the direction perpendicular to the main surface of the base substrate 101 is L2, and L1 is smaller than L2. Therefore, the partition structure 107 can separate at least the first charge generation layer 202 and the second charge generation layer 204 corresponding to different sub-pixels to prevent the lateral drift of charges between adjacent sub-pixels, thereby further avoiding the crosstalk between adjacent sub-pixels caused by the first charge generation layer and the second charge generation layer with higher conductivity, and the display problem of crosstalk between sub-pixels which is easy to occur in the display substrate with a stacked structure can be removed.

For example, in the structure shown in Fig. 2, the first charge generation layer 202 includes a first electron generation sub-layer 2021 configured to form electrons and a first hole generation sub-layer 2022 configured to form holes, which are stacked. The second charge generation layer 204 includes a second electron generation sub-layer 2041 configured to form electrons and a second hole generation sub-layer 2042 configured to form holes, which are stacked. In the structure shown in Fig. 2, a distance between a surface, which is farthest from the pixel defining layer 102, of a portion of the second hole generation sub-layer 2042 located on the pixel spacing portion 104 and the pixel defining layer 102 is smaller than a height of the partition structure 107 in the direction perpendicular to the main surface of the base substrate 101.

For example, in the structure shown in Fig. 2, the distance between the surface, which is farthest from the pixel defining layer 102, of the portion of the second hole generation sub-layer 2042 located on the pixel spacing portion 104 and the pixel defining layer 102 is L1, and the height of the partition structure 107 in the direction perpendicular to the main surface of the base substrate 101 is L2, L1 is greater than or equal to 0.12µm and less than or equal to 0.14µm, and L2 is greater than or equal to 0.42µm and less than or equal to 1.45µm. For example, L2 may be 1 to 10 times as large as L1.

For example, in one example, the height L2 of the partition structure 107 in the direction perpendicular to the main surface of the base substrate 101 is 1.45µm, and the distance L1 between the surface, which is farthest from the pixel defining layer 102, of the portion of the second hole generation sub-layer 2042 located on the pixel spacing portion 104 and the pixel defining layer 102 is 0.14µm.

For example, in one example, the height L2 of the partition structure 107 in the direction perpendicular to the main surface of the base substrate 101 is 1.05µm, and the distance L1 between the surface, which is farthest from the pixel defining layer 102, of the portion of the second hole generation sub-layer 2042 located on the pixel spacing portion 104 and the pixel defining layer 102 is 0.13µm.

For example, in one example, the height L2 of the partition structure 107 in the direction perpendicular to the main surface of the base substrate 101 is 0.85µm, and the distance L1 between the surface, which is farthest from the pixel defining layer 102, of the portion of the second hole generation sub-layer 2042 located on the pixel spacing portion 104 and the pixel defining layer 102 is 0.13µm.

For example, in one example, the height L2 of the partition structure 107 in the direction perpendicular to the main surface of the base substrate 101 is 0.71µm, and the distance L1 between the surface, which is farthest from the pixel defining layer 102, of the portion of the second hole generation sub-layer 2042 located on the pixel spacing portion 104 and the pixel defining layer 102 is 0.13µm.

For example, in one example, the height L2 of the partition structure 107 in the direction perpendicular to the main surface of the base substrate 101 is 0.42µm, and the distance L1 between the surface, which is farthest from the pixel defining layer 102, of the portion of the second hole generation sub-layer 2042 located on the pixel spacing portion 104 and the pixel defining layer 102 is 0.13µm.

For example, in one example, the height L2 of the partition structure 107 in the direction perpendicular to the main surface of the base substrate 101 is 0.42µm, and the distance L1 between the surface, which is farthest from the pixel defining layer, of the portion of the second hole generation sub-layer 2042 located on the pixel spacing portion 104 and the pixel defining layer 102 is 0.12µm.

For example, in the structures shown in Fig. 1 and Fig. 2, a plurality of sub-pixels 105 may be arranged in an array along a first direction and a second direction that cross each other. For the partition structure 107 between two sub-pixels 105 adjacent in the first direction, two edges of the partition structure 107 protrude relative to the corresponding edges of the pixel spacing portion 104.

For example, Fig. 1 shows that one partition structure 107 is arranged between two adjacent sub-pixels 105, but the embodiment of the present disclosure is not limited thereto, and two or more partition structures can be arranged between two adjacent sub-pixels 105. By setting the number of partition structures, the second charge generation layer 204 can be effectively disconnected.

For example, in the structures shown in Fig. 1 and Fig. 2, the material of the partition structure 107 may include any one or more of silicon nitride, silicon oxide or silicon oxynitride.

For example, the conductivity of the first charge generation layer 202 and the conductivity of the second charge generation layer 204 are both greater than the conductivity of the first organic light emitting layer 304 and the second organic light emitting layer 309, and less than the conductivity of the second electrode 1063.

For example, Fig. 3 is a schematic cross-sectional structure of another display substrate provided by at least one embodiment of the present disclosure. The difference between the structures shown in Fig. 3 and Fig. 1 lies is that, in the structure shown in Fig. 3, the second electrode 1063 is located on the partition structure 107, and the surface of the light emitting functional layer 1061 away from the base substrate 101 is flush with the surface of the partition structure 107, that is, the light emitting functional layer 1061 is disconnected at the partition structure 107. However, the second electrode 1063 remains continuous without being separated, so as to prevent crosstalk between adjacent sub-pixels, and at the same time, the second electrode is not separated, which ensures the display uniformity when the display substrate is used in a display panel for displaying.

For example, Fig. 4 is a schematic cross-sectional view of a partial layer structure of a light emitting functional layer, a pixel defining layer and a partition structure in Fig. 3. The light emitting functional layer 1061 includes a first organic light emitting functional layer 201, a first charge generation layer 202, a second organic light emitting functional layer 203, a second charge generation layer 204 and a third organic light emitting functional layer 205 which are at least partially stacked on the pixel spacing portion 104 in the direction perpendicular to the main surface of the base substrate 101, and a surface, which is farthest from the pixel defining layer 102, of a portion of the second charge generation layer 204 located on the pixel spacing portion 104 and the pixel defining layer 105 is smaller than a height of the partition structure 107 in the direction perpendicular to the main surface of the base substrate 101. For example, the surface of the partition structure 107 away from the base substrate 101 is flush with the surface of the third organic light emitting functional layer 205 away from the base substrate 101, and the second electrode 1063 is provided on the partition structure 107. For example, in the structures shown in Fig. 3 and Fig. 4, the distance between the surface, which is farthest from the pixel defining layer, of the portion of the second charge generation layer 204 located on the pixel spacing portion 104 and the pixel defining layer 102 is L1, the height of the partition structure 107 in the direction perpendicular to the main surface of the base substrate 101 is L2, and L1 is smaller than L2. Therefore, the partition structure 107 can separate at least the first charge generation layer 202 and the second charge generation layer 204 corresponding to different sub-pixels to prevent the lateral drift of charges between adjacent sub-pixels, thereby further avoiding the crosstalk between adjacent sub-pixels caused by the first charge generation layer and the second charge generation layer with higher conductivity, and the display problem of crosstalk between sub-pixels which is easy to occur in the display substrate with a stacked structure can be removed.

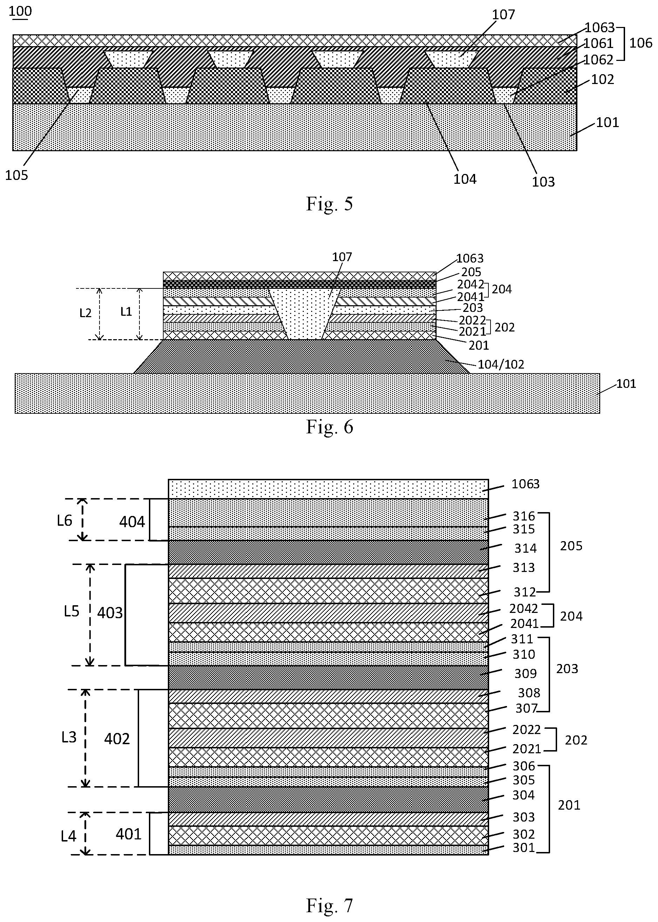

For example, Fig. 5 is a schematic cross-sectional structure diagram of another display substrate provided by at least one embodiment of the present disclosure, and Fig. 6 is a schematic cross-sectional view of a partial layer structure of a light emitting functional layer, a pixel defining layer and a partition structure in Fig. 5. Combining with Fig. 5 and Fig. 6, the structure shown in Fig. 5 is different from that shown in Fig. 1 in that, in the structure shown in Fig. 5, the second electrode 1063 and the third organic light emitting functional layer 205 are both located on the partition structure 107, and a surface of the second hole generation sub-layer 2042 away from the base substrate 101 is flush with the surface of the partition structure 107 away from the base substrate 101, that is, the distance between a surface, which is farthest from the pixel defining layer 102, of the portion of the second charge generation layer 204 and the pixel defining layer 102 is equal to the height of the partition structure 107 in the direction perpendicular to the main surface of the base substrate 101. That is, the second charge generation layer 204 and the layer structures under the second charge generation layer 204 in the light emitting functional layer 1061 are disconnected at the partition structure 107, while the second electrode 1063 remains continuous without being separated, thus preventing the phenomenon of crosstalk between adjacent sub-pixels, while the second electrode is not separated and ensuring the display uniformity when the display substrate is used in a display panel for displaying.

For example, as illustrated by Fig. 5 and Fig. 6, the light emitting functional layer 1061 includes a first organic light emitting functional layer 201, a first charge generation layer 202, a second organic light emitting functional layer 203, a second charge generation layer 204 and a third organic light emitting functional layer 205 which are at least partially stacked on the pixel spacing portion 104 in the direction perpendicular to the main surface of the base substrate 101, and the distance between the surface, which is farthest from the pixel defining layer 102, of the portion of the second charge generation layer 204 located on the pixel spacing portion 104 and the pixel defining layer 102 is equal to the height of the partition structure 107 in the direction perpendicular to the main surface of the base substrate 101. That is, the second electrode 1063 and the third organic light emitting functional layer 205 are arranged on the partition structure 107. For example, in the structures shown in Fig. 5 and Fig. 6, the distance between the surface, which is farthest from the pixel defining layer 102, of the portion of the second charge generation layer 204 located on the pixel spacing portion 104 and the pixel defining layer 102 is L1, the height of the partition structure 107 in the direction perpendicular to the main surface of the base substrate 101 is L2, and L1 is equal to L2. Therefore, the partition structure 107 can separate at least the first charge generation layer 202 and the second charge generation layer 204 corresponding to different sub-pixels to prevent the lateral drift of charges between adjacent sub-pixels, thereby further avoiding the crosstalk between adjacent sub-pixels caused by the first charge generation layer and the second charge generation layer with higher conductivity, and the display problem of crosstalk between sub-pixels which is easy to occur in the display substrate with a stacked structure can be removed.

For example, Fig. 7 is a schematic cross-sectional view of each layer structure of a display substrate provided by at least one embodiment of the present disclosure. Combining with Fig. 2, Fig. 4, Fig. 6 and Fig. 7, the first organic light emitting functional layer 201 includes a hole injection layer 301, a first hole transport layer 302, a first electron blocking layer 303, a first organic light emitting layer 304, a first hole blocking layer 305 and a first electron transport layer 306 which are stacked. The first charge generation layer 202 includes a first electron generation sub-layer 2021 and a first hole generation sub-layer 2022 which are stacked. The second organic light emitting functional layer 203 includes a second hole transport layer 307, a second electron blocking layer 308, a second organic light emitting layer 309, a second hole blocking layer 310 and a second electron transport layer 311. The second charge generation layer 204 includes a second electron generation sub-layer 2041 and a second hole generation sub-layer 2042 which are stacked. The third organic light emitting functional layer 205 includes a third hole transport layer 312, a third electron blocking layer 313, a third organic light emitting layer 314, a third hole blocking layer 315 and a third electron transport layer 316 which are stacked.

For example, in the structure shown in Fig. 7, the hole injection layer 301, the first hole transport layer 302 and the first electron blocking layer 303 constitute a first organic functional layer 401. The first hole blocking layer 305, the first electron transport layer 306, the first electron generation sub-layer 2021, the first hole generation sub-layer 2022, the second hole transport layer 307 and the second electron blocking layer 308 constitute a second organic functional layer 402. The second hole blocking layer 310, the second electron transport layer 311, the second electron generation sub-layer 2041, the second hole generation sub-layer 2042, the third electron blocking layer 313 and the third electron transport layer 316 constitute a third organic functional layer 403. The third hole blocking layer 315 and the third electron transport layer 316 constitute a fourth organic functional layer 404.

For example, as illustrated by Fig. 7, the relationship between the thickness L3 of the second organic functional layer 402 and the thickness L4 of the first organic functional layer 401 is L3 > L4.

For example, in the display substrate provided by at least one embodiment of the present disclosure, the relationship between the thickness L5 of the third organic functional layer 403 and the thickness L6 of the fourth organic functional layer 404 is L5 > L6.

For example, in the display substrate provided by at least one embodiment of the present disclosure, the thickness L3 of the second organic functional layer 402 is less than or equal to the thickness L5 of the third organic functional layer 403, that is, when the thickness L3 of the second organic functional layer 402 is less than the thickness L5 of the third organic functional layer 403, the thickness L4 of the first organic functional layer 401, the thickness L3 of the second organic functional layer 402 and the thickness L5 of the third organic functional layer 403 become larger in sequence.

For example, by designing the thickness of the above layer structures, the lateral drift of charges between adjacent sub-pixels can be further prevented, so as to avoid the crosstalk between adjacent sub-pixels caused by the charge generation layer with high conductivity, and further the display problem of crosstalk between sub-pixels which is easy to occur in the display substrate with a stacked structure can be removed.

For example, with reference to Fig. 7, in the display substrate provided by at least one embodiment of the present disclosure, at least one sub-pixel is a red sub-pixel, and the thickness of the first organic light emitting layer 304, the thickness of the second organic light emitting layer 309 and the thickness of the third organic light emitting layer 314 in the red sub-pixel are all greater than a thickness of a thickest one of sub-layers in the first organic functional layer 401, and are all greater than a thickness of a thickest one of sub-layers in the third organic functional layer 403, so that when the display substrate is used for display in a display panel, the color purity of the emitted red light can be improved.

For example, with reference to Fig. 7, in the display substrate provided by at least one embodiment of the present disclosure, at least one sub-pixel is a blue sub-pixel, and the thickness of the first organic light emitting layer 304, the thickness of the second organic light emitting layer 309 and the thickness of the third organic light emitting layer 314 in the blue sub-pixel are all smaller than a thickness of a thickest one of sub-layers in the first organic functional layer 401, and are all smaller than a thickness of a thickest one of sub-layers in the third organic functional layer 403, so that when the display substrate is used for display in a display panel, the color purity of the emitted blue light can be improved.

For example, the materials of the first organic light emitting layer 304 and the second organic light emitting layer 309 may be selected from pyrene derivatives, anthracene derivatives, fluorene derivatives, perylene derivatives, styrylamine derivatives, metal complexes and the like.

For example, the material of the hole injection layer 301 may include oxides, such as molybdenum oxide, titanium oxide, vanadium oxide, rhenium oxide, ruthenium oxide, chromium oxide, zirconium oxide, hafnium oxide, tantalum oxide, silver oxide, tungsten oxide and manganese oxide.

For example, the material of the hole injection layer can also include organic materials, such as: hexacyanohexaazatriphenyl, 2,3,5,6-tetrafluoro-7,7,8,8-tetracyano-p-quinonedimethane (F4TCNQ), and 1,2,3-tris[(cyano)(4-cyano-2,3,5,6-tetrafluorophenyl) methylene] cyclopropane.

For example, the materials of the first hole transport layer 302, the second hole transport layer 307 and the third hole transport layer 312 may include aromatic amines with hole transport characteristics and dimethylfluorene or carbazole materials, such as 4,4'-bis[N-(1-Naphthyl)-N-phenylamino]biphenyl, N,N'-bis(3- methylphenyl)-N, N'-diphenyl-[1,1'-biphenyl]-4,4'-diamine (TPD), 4-phenyl-4'-(9-phenylfluorene-9-yl) triphenylamine (BAFLP), 4,4'-bis[N-(9,9-dimethylfluorene-2-yl)-N-phenylamino]biphenyl (DFLDPBi), 4,4'-bis(9-carbazolyl)biphenyl (CBP), and 9-phenyl-3-[4-(10-phenyl-9-anthracenyl) phenyl]-9H-carbazole (PCzPA).

For example, the materials of the first electron transport layer 306, the second electron transport layer 311 and the third electron transport layer 316 may include aromatic heterocyclic compounds, such as benzimidazole derivatives, imidazole derivatives, pyrimidine derivatives, azine derivatives, quinoline derivatives, isoquinoline derivatives, phenanthroline derivatives and the like.

For example, although not shown in Fig. 7, combined with Fig. 2, Fig. 4 and Fig. 6, the light emitting functional layer 1061 further includes an electron injection layer between the third organic light emitting functional layer 205 and the second electrode 1063, and the material of the electron injection layer can be alkali metal or metal and their compounds, such as lithium fluoride (LiF), ytterbium (Yb), magnesium (Mg) and calcium (Ca).

For example, with reference to Fig. 1, Fig. 3 and Fig. 5, the first electrode 1062 may be made of a metal material, such as any one or more of magnesium (Mg), silver (Ag), copper (Cu), aluminum (Al), titanium (Ti) and molybdenum (Mo), or an alloy material of the above metals, such as aluminum neodymium alloy (AlNd) or molybdenum niobium alloy (MoNb). The first electrode 1062 may be a single-layer structure or a multi-layer composite structure, such as Ti/Al/Ti, or the first electrode 501 may be a stacked structure formed of metal and transparent conductive materials, such as ITO/Ag/ITO, Mo/AlNd/ITO, etc.

For example, in some examples, the second electrode 1063 may adopt any one or more materials of magnesium (Mg), silver (Ag) and aluminum (Al), or may be an alloy made of any one or more of the above metals, or the second electrode 1063 may adopt a transparent conductive material, such as indium tin oxide (ITO), or a multi-layer composite structure of metal and transparent conductive material.

For example, in some examples, the first charge generation layer 202 and the second charge generation layer 204 are both configured to generate carriers, transport carriers and inject carriers. For example, the materials of the first charge generation layer 202 and the second charge generation layer 204 may include an n-doped organic layer/inorganic metal oxide, for example, Alq₃:Mg/WO₃, Bphen:Li/MoO₃, BCP:Li/V₂O₅, and BCP:Cs/V₂O₅; or, an n-type doped organic layer/organic layer, such as Alq₃:Li/HAT-CN; or, an n-type doped organic layer/p-type doped organic layer, such as BPhen:Cs/NPB:F4-TCNQ, Alq₃:Li/NPB:FeCl₃, TPBi:Li/NPB:FeCl₃ and Alq₃:Mg/m-MTDATA:F4-TCNQ; or, an undoped type, such as F16CuPc/CuPc and Al/WO₃/Au.

For example, in some examples, the material of the base substrate 101 may be made of one or more materials of glass, polyimide, polycarbonate, polyacrylate, polyetherimide and polyethersulfone, and embodiments of the present disclosure include but are not limited thereto.

For example, in some examples, the base substrate may be a rigid substrate or a flexible substrate; in the case that the base substrate is a flexible substrate, the base substrate may include a first flexible material layer, a first inorganic material layer, a semiconductor layer, a second flexible material layer and a second inorganic material layer which are sequentially stacked. The materials of the first flexible material layer and the second flexible material layer are polyimide (PI), polyethylene terephthalate (PET) or polymer soft film with surface treatment. The materials of the first inorganic material layer and the second inorganic material layer are silicon nitride (SiNx) or silicon oxide (SiOx), which are used to improve the water-oxygen resistance of the base substrate. The first inorganic material layer and the second inorganic material layer are also called barrier layers. The material of the semiconductor layer is amorphous silicon (a-si).

For example, taking the case that the base substrate is a stacked structure of PI1/Barrier1/a-si/PI2/Barrier2 as an example, the preparation process of the base substrate includes: coating a layer of polyimide on a glass carrier, curing to form a film, and then forming a first flexible layer (PI1); subsequently, depositing a barrier film on the first flexible layer to form a first barrier layer (Barrier1) covering the first flexible layer; then depositing an amorphous silicon film on the first barrier layer to form an amorphous silicon (a-si) layer covering the first barrier layer; then coating a layer of polyimide on the amorphous silicon layer, and curing to form a film to form a second flexible layer (PI2); then, depositing a barrier film on the second flexible layer to form a second barrier layer (Barrier2) covering the second flexible layer, and finally the preparation of the base substrate is completed.

For example, in combination with Fig. 1, Fig. 3 and Fig. 5, a plurality of pixel openings respectively define effective light emitting regions of corresponding sub-pixels, and each of the plurality of pixel openings is configured to expose the first electrode 1062 so that the first electrode 1062 is in contact with a subsequently formed light emitting functional layer.

For example, a manufacturing method of the display substrate provided by the embodiment of the present disclosure may include: cleaning a glass carrier and preparing the base substrate 101 on the glass carrier. For example, the base substrate 110 may be a flexible base substrate. For example, forming the base substrate 101 may include sequentially forming a first flexible material layer, a first inorganic material layer, a semiconductor layer, a second flexible material layer and a second inorganic material layer on the glass carrier. The materials of the first flexible material layer and the second flexible material layer are polyimide (PI), polyethylene terephthalate (PET) or polymer soft film with surface treatment. The materials of the first inorganic material layer and the second inorganic material layer are silicon nitride (SiNx) or silicon oxide (SiOx), which are used to improve the water-oxygen resistance of the base substrate. The first inorganic material layer and the second inorganic material layer are also called barrier layers.

For example, before forming the first electrode and the pixel defining layer 102, a driving structure layer of a pixel circuit may be formed on the base substrate 101. The driving structure layer includes a plurality of pixel circuits, and each pixel circuit includes a plurality of transistors and at least one storage capacitor. For example, the pixel circuits can adopt 2T1C, 3T1C or 7T1C designs. For example, forming the driving structure layer may include sequentially depositing a first insulating film and an active layer film on the base substrate 101, patterning the active layer film through a patterning process to form a first insulating layer covering the whole base substrate 101 and an active layer pattern arranged on the first insulating layer, the active layer pattern at least includes the active layer. For example, a second insulating film and a first metal film are sequentially deposited, and the first metal film is patterned by a patterning process to form a second insulating layer covering the active layer pattern and a first gate metal layer pattern arranged on the second insulating layer, the first gate metal layer pattern at least includes a gate electrode and a first capacitor electrode. For example, a third insulating film and a second metal film are sequentially deposited, and the second metal film is patterned by a patterning process to form a third insulating layer covering the first gate metal layer and a second gate metal layer pattern arranged on the third insulating layer, the second gate metal layer pattern at least includes a second capacitor electrode, and the position of the second capacitor electrode corresponds to the position of the first capacitor electrode. Then, a fourth insulating film is deposited, and the fourth insulating film is patterned by a patterning process to form a fourth insulating layer covering the second gate metal layer. At least two first via holes are formed in the fourth insulating layer, and the fourth insulating layer, the third insulating layer and the second insulating layer in the two first via holes are etched away to expose the surface of the active layer of the active layer pattern. Then, a third metal film is deposited and patterned by a patterning process, and a source-drain metal layer pattern is formed on the fourth insulating layer, the source-drain metal layer pattern at least includes a source electrode and a drain electrode located in the display region. The source electrode and the drain electrode may be connected with the active layer in the active layer pattern through the first via holes, respectively.

For example, the first insulating layer, the second insulating layer, the third insulating layer and the fourth insulating layer may adopt any one or more of silicon oxide (SiOx), silicon nitride (SiNx) and silicon oxynitride (SiON), and may be a single layer, a multi-layer or a composite layer. The first insulating layer may be a buffer layer for improving the water and oxygen resistance of the base substrate 110; the second insulating layer and the third insulating layer may be gate insulating layers (GI); the fourth insulating layer may be an interlayer dielectric layer (ILD). The first metal thin film, the second metal thin film and the third metal thin film are made of metal materials, such as any one or more of silver (Ag), copper (Cu), aluminum (Al), titanium (Ti) and molybdenum (Mo), or alloy materials of the above metals, such as aluminum-neodymium alloy (AlNd) or molybdenum-niobium alloy (MoNb), which can be single-layer structures or multi-layer composite structures, such as Ti/Al/Ti. The active layer film is made of one or more materials such as amorphous indium gallium zinc oxide (a-IGZO), zinc oxynitride (ZnON), indium zinc tin oxide (IZTO), amorphous silicon (a-Si), polysilicon (p-Si), hexathiophene, polythiophene, etc., that is, the present disclosure is suitable for transistors manufactured based on oxide technology, silicon technology and organic technology.

For example, in one example, after the driving structure layer is formed, the planarization layer and the first electrode are formed. For example, the first electrode is connected with the drain electrode of the transistor through a via hole structure in the planarization layer.

For example, the first electrode may be formed of a metal material including any one or more of magnesium (Mg), silver (Ag), copper (Cu), aluminum (Al), titanium (Ti) and molybdenum (Mo), or an alloy material of the above metals, such as aluminum-neodymium alloy (AlNd) or molybdenum-niobium alloy (MoNb). The first electrode can be a single-layer structure, a multi-layer composite structure, such as Ti/Al/Ti, or a sandwich structure formed of metal and transparent conductive materials, such as ITO/Ag/ITO, Mo/AlNd/ITO and other reflective materials.

For example, after forming the first electrode, a pixel defining layer may be formed. For example, a pixel-defining film is coated on the base substrate with the above-mentioned pattern, and a pixel defining layer is formed through mask, exposure and development processes. For example, the pixel defining layer in the display region includes a plurality of pixel spacing portions, and a pixel opening is formed between adjacent pixel spacing portions, and the pixel defining film in the pixel opening is developed, and the pixel openings expose at least a part of the surfaces of the first electrodes of a plurality of sub-pixels.

For example, after the pixel defining layer is formed, an inorganic insulating material is applied on the pixel spacing portion to form an inorganic insulating layer, and the inorganic insulating layer is patterned to form a partition structure. For this patterning process, please refer to the above-mentioned method for forming the pixel defining layer.

For example, after the pixel defining layer and the partition structure are formed, spacers can be formed on the pixel spacing portions located at the edge of the base substrate and not provided with the partition structure. For example, a thin film of organic material is coated on the base substrate with the above patterns, and the spacer is formed through mask, exposure and development processes. The spacer can be used as a support layer and configured to support FMM (Fine Metal Mask) during evaporation.

For example, after the spacer is formed, the light emitting functional layer and the second electrode are sequentially formed. For example, the second electrode may be a transparent cathode. The light emitting functional layer can emit light from a side away from the base substrate through the transparent cathode to realize top emission. For example, the second electrode may be formed of any one or more metal materials such as magnesium (Mg), silver (Ag) and aluminum (Al), or an alloy made of any one or more of the above metals, or a transparent conductive material such as indium tin oxide (ITO), or a multi-layer composite structure formed by metals and transparent conductive materials.

For example, with reference to Fig. 7, forming a light emitting functional layer may include: sequentially forming a hole injection layer 301, a first hole transport layer 302, and a first electron blocking layer 303 by evaporation using an open mask, and then sequentially forming first organic light emitting layers 304 emitting light of different colors by evaporation using FMM, such as a blue light emitting layer, a green light emitting layer, and a red light emitting layer; sequentially forming a first hole blocking layer 305, a first electron transport layer 306, a first charge generation layer 202, a second hole transport layer 307 and a second electron blocking layer 308 by evaporation using an open mask. The second organic light emitting layers 309 emitting light of different colors, for example, a blue light emitting layer, a green light emitting layer and a red light emitting layer, are sequentially formed by evaporation using FMM. A second hole blocking layer 310, a second electron transport layer 311, a second charge generation layer 204, a third hole transport layer 312 and a third electron blocking layer 313 are formed by evaporation in sequence by using an open mask. The third organic light emitting layer 314 emitting light of different colors, for example, a blue light emitting layer, a green light emitting layer and a red light emitting layer, are sequentially formed by evaporation using FMM. A third hole blocking layer 315 and a third electron transport layer 316 are sequentially formed by evaporation using an open mask.

For example, in the structure shown in Fig. 7, the hole injection layer 301, the first hole transport layer 302, the first electron blocking layer 303, the first hole blocking layer 305, the first electron transport layer 306, the first charge generation layer 202, the second hole transport layer 307, the second electron blocking layer 308, the second hole blocking layer 310, the second electron transport layer 311, the second charge generation layer 204, the third hole transport layer 312, the third electron blocking layer 313, the third hole blocking layer 315, the third electron transport layer 316, and the second electrode 1063 are common layers of the plurality of sub-pixels.

For example, the formed light emitting functional layer will be disconnected at the position away from the base substrate of the partition structure, so that a portion of the light emitting functional layer located in the pixel opening of the pixel defining layer is located on the pixel spacing portion and the other part is located in the pixel opening.

For example, in one example, after forming the second electrode, the manufacturing method of the display substrate further includes forming an encapsulation layer, which may include a first encapsulation layer, a second encapsulation layer and a third encapsulation layer which are stacked. The first encapsulation layer is made of inorganic material and covers the second electrode in the display region. The second encapsulation layer is made of organic material. The third encapsulation layer is made of inorganic material and covers the first encapsulation layer and the second encapsulation layer. However, this embodiment is not limited thereto. For example, the encapsulation layer can also adopt a five-layer structure of inorganic/organic/inorganic/organic/inorganic.

For example, compared with the display substrate without the partition structure, the display substrate with the partition structure provided by the embodiment of the present disclosure only adds one mask process, which has a lower impact on the production cost.

For example, referring to first comparative example, the display performance of the display substrate provided by the embodiment of the present disclosure when used in a display panel can be studied based on the following first embodiment to the sixth embodiment.

### First embodiment:

The height L2 of the partition structure 107 in the direction perpendicular to the main surface of the base substrate 101 is 1.45 microns, the distance L1 between the surface, which is farthest from the pixel defining layer, of the portion of the second hole generation sub-layer 2042 located on the pixel spacing portion 104 and the pixel defining layer 102 is 0.14 microns, the thickness of the hole injection layer 301 is 100 microns, and the thickness of the first hole transport layer 302 is 180 microns, the thickness of the first electron blocking layer 303 corresponding to the blue sub-pixel is 50 microns, the thickness of the first electron blocking layer 303 corresponding to the green sub-pixel is 70 microns, and the thickness of the first electron blocking layer 303 corresponding to the red sub-pixel is 200 microns, the thickness of the first organic light emitting layer 304 corresponding to the blue sub-pixel is 170 microns, the thickness of the first organic light emitting layer 304 corresponding to the green sub-pixel is 350 microns, the thickness of the first organic light emitting layer 304 corresponding to the red sub-pixel is 450 microns, the thickness of the first hole blocking layer 305 is 50 microns, and the thickness of the first electron transport layer 306 is 150 microns. The thickness of the first electron generation sub-layer 2021 is 120 microns, and the thickness of the first hole generation sub-layer 2022 is 90 microns. The thickness of the second hole transport layer 307 is 250 microns, the thickness of the second electron blocking layer 308 corresponding to the blue sub-pixel is 50 microns, the thickness of the second electron blocking layer 308 corresponding to the green sub-pixel is 70 microns, the thickness of the second electron blocking layer 308 corresponding to the red sub-pixel is 200 microns, and the thickness of the second organic light emitting layer 309 corresponding to the blue sub-pixel is 170 microns. The thickness of the second organic light emitting layer 309 corresponding to the green sub-pixel is 350 microns, the thickness of the second organic light emitting layer 309 corresponding to the red sub-pixel is 450 microns, the thickness of the second hole blocking layer 310 is 50 microns, and the thickness of the second electron transport layer 311 is 160 microns. The thickness of the second electron generation sub-layer 2041 is 120 microns, and the thickness of the second hole generation sub-layer 2042 is 90 microns. The thickness of the third hole transport layer 312 is 250 microns, the thickness of the third electron blocking layer 313 corresponding to the blue sub-pixel is 50 microns, the thickness of the third electron blocking layer 313 corresponding to the green sub-pixel is 70 microns, and the thickness of the third electron blocking layer 313 corresponding to the red sub-pixel is 200 microns. The thickness of the third organic light emitting layer 314 corresponding to the blue sub-pixel is 170 microns, the thickness of the third organic light emitting layer 314 corresponding to the green sub-pixel is 350 microns, the thickness of the third organic light emitting layer 314 corresponding to the red sub-pixel is 450 microns, the thickness of the third hole blocking layer 315 is 50 microns, and the thickness of the third electron transport layer 316 is 150 microns.

### Second embodiment:

The height L2 of the partition structure 107 in the direction perpendicular to the main surface of the base substrate 101 is 1.05 microns, the distance L1 between the surface, which is farthest from the pixel defining layer, of the portion of the second hole generation sub-layer 2042 located on the pixel spacing portion 104 and the pixel defining layer 102 is 0.13 microns, the thickness of the hole injection layer 301 is 90 microns, and the thickness of the first hole transport layer 302 is 200 microns. The thickness of the first electron blocking layer 303 corresponding to the blue sub-pixel is 80 microns, the thickness of the first electron blocking layer 303 corresponding to the green sub-pixel is 100 microns, and the thickness of the first electron blocking layer 303 corresponding to the red sub-pixel is 300 microns. The thickness of the first organic light emitting layer 304 corresponding to the blue sub-pixel is 160 microns, the thickness of the first organic light emitting layer 304 corresponding to the green sub-pixel is 330 microns, the thickness of the first organic light emitting layer 304 corresponding to the red sub-pixel is 420 microns, the thickness of the first hole blocking layer 305 is 50 microns, and the thickness of the first electron transport layer 306 is 120 microns. The thickness of the first electron generation sub-layer 2021 is 110 microns, and the thickness of the first hole generation sub-layer 2022 is 90 microns. The thickness of the second hole transport layer 307 is 240 microns, the thickness of the second electron blocking layer 308 corresponding to the blue sub-pixel is 80 microns, the thickness of the second electron blocking layer 308 corresponding to the green sub-pixel is 100 microns, the thickness of the second electron blocking layer 308 corresponding to the red sub-pixel is 300 microns, and the thickness of the second organic light emitting layer 309 corresponding to the blue sub-pixel is 160 microns. The thickness of the second organic light emitting layer 309 corresponding to the green sub-pixel is 330 microns, the thickness of the second organic light emitting layer 309 corresponding to the red sub-pixel is 420 microns, the thickness of the second hole blocking layer 310 is 50 microns, and the thickness of the second electron transport layer 311 is 120 microns. The thickness of the second electron generation sub-layer 2041 is 120 microns, and the thickness of the second hole generation sub-layer 2042 is 90 microns. The thickness of the third hole transport layer 312 is 240 microns, the thickness of the third electron blocking layer 313 corresponding to the blue sub-pixel is 80 microns, the thickness of the third electron blocking layer 313 corresponding to the green sub-pixel is 100 microns, and the thickness of the third electron blocking layer 313 corresponding to the red sub-pixel is 300 microns. The thickness of the third organic light emitting layer 314 corresponding to the blue sub-pixel is 160 microns, the thickness of the third organic light emitting layer 314 corresponding to the green sub-pixel is 330 microns, the thickness of the third organic light emitting layer 314 corresponding to the red sub-pixel is 420 microns, the thickness of the third hole blocking layer 315 is 50 microns, and the thickness of the third electron transport layer 316 is 120 microns.

### Third embodiment:

The height L2 of the partition structure 107 in the direction perpendicular to the main surface of the base substrate 101 is 0.85 microns, the distance L1 between the surface, which is farthest from the pixel defining layer, of the portion of the second hole generation sub-layer 2042 located on the pixel spacing portion 104 and the pixel defining layer 102 is 0.13 microns, the thickness of the hole injection layer 301 is 100 microns, and the thickness of the first hole transport layer 302 is 150 microns. The thickness of the first electron blocking layer 303 corresponding to the blue sub-pixel is 60 microns, the thickness of the first electron blocking layer 303 corresponding to the green sub-pixel is 75 microns, and the thickness of the first electron blocking layer 303 corresponding to the red sub-pixel is 290 microns. The thickness of the first organic light emitting layer 304 corresponding to the blue sub-pixel is 200 microns, the thickness of the first organic light emitting layer 304 corresponding to the green sub-pixel is 360 microns, the thickness of the first organic light emitting layer 304 corresponding to the red sub-pixel is 440 microns, the thickness of the first hole blocking layer 305 is 60 microns, and the thickness of the first electron transport layer 306 is 130 microns. The thickness of the first electron generation sub-layer 2021 is 110 microns, and the thickness of the first hole generation sub-layer 2022 is 100 microns. The thickness of the second hole transport layer 307 is 230 microns, the thickness of the second electron blocking layer 308 corresponding to the blue sub-pixel is 60 microns, the thickness of the second electron blocking layer 308 corresponding to the green sub-pixel is 75 microns, the thickness of the second electron blocking layer 308 corresponding to the red sub-pixel is 290 microns. The thickness of the second organic light emitting layer 309 corresponding to the blue sub-pixel is 200 microns, the thickness of the second organic light emitting layer 309 corresponding to the green sub-pixel is 360 microns, the thickness of the second organic light emitting layer 309 corresponding to the red sub-pixel is 440 microns, the thickness of the second hole blocking layer 310 is 60 microns, and the thickness of the second electron transport layer 311 is 130 microns. The thickness of the second electron generation sub-layer 2041 is 110 microns, and the thickness of the second hole generation sub-layer 2042 is 100 microns. The thickness of the third hole transport layer 312 is 230 microns, the thickness of the third electron blocking layer 313 corresponding to the blue sub-pixel is 60 microns, the thickness of the third electron blocking layer 313 corresponding to the green sub-pixel is 75 microns, and the thickness of the third electron blocking layer 313 corresponding to the red sub-pixel is 290 microns. The thickness of the third organic light emitting layer 314 corresponding to the blue sub-pixel is 200 microns, the thickness of the third organic light emitting layer 314 corresponding to the green sub-pixel is 360 microns, the thickness of the third organic light emitting layer 314 corresponding to the red sub-pixel is 440 microns, the thickness of the third hole blocking layer 315 is 60 microns, and the thickness of the third electron transport layer 316 is 130 microns.

### Fourth embodiment:

The height L2 of the partition structure 107 in the direction perpendicular to the main surface of the base substrate 101 is 0.71 micron, the distance L1 between the surface, which is farthest from the pixel defining layer, of the portion of the second hole generation sub-layer 2042 located on the pixel spacing portion 104 and the pixel defining layer is 0.13 micron, the thickness of the hole injection layer 301 is 110 micron, and the thickness of the first hole transport layer 302 is 160 micron. The thickness of the first electron blocking layer 303 corresponding to the blue sub-pixel is 50 microns, the thickness of the first electron blocking layer 303 corresponding to the green sub-pixel is 60 microns, and the thickness of the first electron blocking layer 303 corresponding to the red sub-pixel is 280 microns. The thickness of the first organic light emitting layer 304 corresponding to the blue sub-pixel is 180 microns, the thickness of the first organic light emitting layer 304 corresponding to the green sub-pixel is 340 microns, the thickness of the first organic light emitting layer 304 corresponding to the red sub-pixel is 420 microns, the thickness of the first hole blocking layer 305 is 55 microns, and the thickness of the first electron transport layer 306 is 125 microns. The thickness of the first electron generation sub-layer 2021 is 130 microns, and the thickness of the first hole generation sub-layer 2022 is 80 microns. The thickness of the second hole transport layer 307 is 220 microns, the thickness of the second electron blocking layer 308 corresponding to the blue sub-pixel is 50 microns, the thickness of the second electron blocking layer 308 corresponding to the green sub-pixel is 60 microns, the thickness of the second electron blocking layer 308 corresponding to the red sub-pixel is 280 microns, and the thickness of the second organic light emitting layer 309 corresponding to the blue sub-pixel is 180 microns. The thickness of the second organic light emitting layer 309 corresponding to the green sub-pixel is 340 microns, the thickness of the second organic light emitting layer 309 corresponding to the red sub-pixel is 420 microns, the thickness of the second hole blocking layer 310 is 55 microns, and the thickness of the second electron transport layer 311 is 130 microns. The thickness of the second electron generation sub-layer 2041 is 130 microns, and the thickness of the second hole generation sub-layer 2042 is 80 microns. The thickness of the third hole transport layer 312 is 220 microns, the thickness of the third electron blocking layer 313 corresponding to the blue sub-pixel is 50 microns, the thickness of the third electron blocking layer 313 corresponding to the green sub-pixel is 60 microns, and the thickness of the third electron blocking layer 313 corresponding to the red sub-pixel is 280 microns. The thickness of the third organic light emitting layer 314 corresponding to the blue sub-pixel is 180 microns, the thickness of the third organic light emitting layer 314 corresponding to the green sub-pixel is 340 microns, the thickness of the third organic light emitting layer 314 corresponding to the red sub-pixel is 420 microns, the thickness of the third hole blocking layer 315 is 55 microns, and the thickness of the third electron transport layer 316 is 125 microns.

### Fifth embodiment:

The height L2 of the partition structure 107 in the direction perpendicular to the main surface of the base substrate 101 is 0.42 microns, the distance L1 between the surface, which is farthest from the pixel defining layer, of the portion of the second hole generation sub-layer 2042 located on the pixel spacing portion 104 and the pixel defining layer 102 is 0.12 microns, the thickness of the hole injection layer 301 is 100 microns, and the thickness of the first hole transport layer 302 is 170 microns. The thickness of the first electron blocking layer 303 corresponding to the blue sub-pixel is 45 microns, the thickness of the first electron blocking layer 303 corresponding to the green sub-pixel is 70 microns, and the thickness of the first electron blocking layer 303 corresponding to the red sub-pixel is 260 microns. The thickness of the first organic light emitting layer 304 corresponding to the blue sub-pixel is 190 microns, the thickness of the first organic light emitting layer 304 corresponding to the green sub-pixel is 320 microns, the thickness of the first organic light emitting layer 304 corresponding to the red sub-pixel is 410 microns, the thickness of the first hole blocking layer 305 is 50 microns, and the thickness of the first electron transport layer 306 is 130 microns. The thickness of the first electron generation sub-layer 2021 is 100 microns, and the thickness of the first hole generation sub-layer 2022 is 90 microns. The thickness of the second hole transport layer 307 is 240 microns, the thickness of the second electron blocking layer 308 corresponding to the blue sub-pixel is 45 microns, the thickness of the second electron blocking layer 308 corresponding to the green sub-pixel is 70 microns, the thickness of the second electron blocking layer 308 corresponding to the red sub-pixel is 260 microns, and the thickness of the second organic light emitting layer 309 corresponding to the blue sub-pixel is 190 microns. The thickness of the second organic light emitting layer 309 corresponding to the green sub-pixel is 320 microns, the thickness of the second organic light emitting layer 309 corresponding to the red sub-pixel is 410 microns, the thickness of the second hole blocking layer 310 is 50 microns, and the thickness of the second electron transport layer 311 is 130 microns. The thickness of the second electron generation sub-layer 2041 is 110 microns, and the thickness of the second hole generation sub-layer 2042 is 90 microns. The thickness of the third hole transport layer 312 is 240 microns, the thickness of the third electron blocking layer 313 corresponding to the blue sub-pixel is 45 microns, the thickness of the third electron blocking layer 313 corresponding to the green sub-pixel is 70 microns, and the thickness of the third electron blocking layer 313 corresponding to the red sub-pixel is 260 microns. The thickness of the third organic light emitting layer 314 corresponding to the blue sub-pixel is 190 microns, the thickness of the third organic light emitting layer 314 corresponding to the green sub-pixel is 320 microns, the thickness of the third organic light emitting layer 314 corresponding to the red sub-pixel is 410 microns, the thickness of the third hole blocking layer 315 is 50 microns, and the thickness of the third electron transport layer 316 is 130 microns.

### Sixth embodiment:

The height L2 of the partition structure 107 in the direction perpendicular to the main surface of the base substrate 101 is 0.42 microns, the distance L1 between the surface, which is farthest from the pixel defining layer 102, of the portion of the second hole generation sub-layer 2042 located on the pixel spacing portion 104 and the pixel defining layer 102 is 0.13 microns, the thickness of the hole injection layer 301 is 90 microns, and the thickness of the first hole transport layer 302 is 160 microns. The thickness of the first electron blocking layer 303 corresponding to the blue sub-pixel is 50 microns, the thickness of the first electron blocking layer 303 corresponding to the green sub-pixel is 80 microns, and the thickness of the first electron blocking layer 303 corresponding to the red sub-pixel is 250 microns. The thickness of the first organic light emitting layer 304 corresponding to the blue sub-pixel is 160 microns, the thickness of the first organic light emitting layer 304 corresponding to the green sub-pixel is 300 microns, the thickness of the first organic light emitting layer 304 corresponding to the red sub-pixel is 390 microns, the thickness of the first hole blocking layer 305 is 50 microns, and the thickness of the first electron transport layer 306 is 140 microns. The thickness of the first electron generation sub-layer 2021 is 110 microns, and the thickness of the first hole generation sub-layer 2022 is 100 microns. The thickness of the second hole transport layer 307 is 260 microns, the thickness of the second electron blocking layer 308 corresponding to the blue sub-pixel is 50 microns, the thickness of the second electron blocking layer 308 corresponding to the green sub-pixel is 80 microns, the thickness of the second electron blocking layer 308 corresponding to the red sub-pixel is 250 microns, and the thickness of the second organic light emitting layer 309 corresponding to the blue sub-pixel is 160 microns. The thickness of the second organic light emitting layer 309 corresponding to the green sub-pixel is 300 microns, the thickness of the second organic light emitting layer 309 corresponding to the red sub-pixel is 390 microns, the thickness of the second hole blocking layer 310 is 50 microns, and the thickness of the second electron transport layer 311 is 140 microns. The thickness of the second electron generation sub-layer 2041 is 120 microns, and the thickness of the second hole generation sub-layer 2042 is 105 microns. The thickness of the third hole transport layer 312 is 260 microns, the thickness of the third electron blocking layer 313 corresponding to the blue sub-pixel is 50 microns, the thickness of the third electron blocking layer 313 corresponding to the green sub-pixel is 80 microns, and the thickness of the third electron blocking layer 313 corresponding to the red sub-pixel is 250 microns. The thickness of the third organic light emitting layer 314 corresponding to the blue sub-pixel is 160 microns, the thickness of the third organic light emitting layer 314 corresponding to the green sub-pixel is 300 microns, the thickness of the third organic light emitting layer 314 corresponding to the red sub-pixel is 390 microns, the thickness of the third hole blocking layer 315 is 50 microns, and the thickness of the third electron transport layer 316 is 140 microns.

### Comparative First embodiment:

The height L2 of the partition structure 107 in the direction perpendicular to the main surface of the base substrate 101 is 0.13 microns, the distance L1 between the surface, which is farthest from the pixel defining layer, of the portion of the second hole generation sub-layer 2042 located on the pixel spacing portion 104 and the pixel defining layer 102 is 0.14 microns, the thickness of the hole injection layer 301 is 100 microns, and the thickness of the first hole transport layer 302 is 450 microns. The thickness of the first electron blocking layer 303 corresponding to the blue sub-pixel is 50 microns, the thickness of the first electron blocking layer 303 corresponding to the green sub-pixel is 60 microns, and the thickness of the first electron blocking layer 303 corresponding to the red sub-pixel is 120 microns. The thickness of the first organic light emitting layer 304 corresponding to the blue sub-pixel is 150 microns, the thickness of the first organic light emitting layer 304 corresponding to the green sub-pixel is 300 microns, the thickness of the first organic light emitting layer 304 corresponding to the red sub-pixel is 400 microns, the thickness of the first hole blocking layer 305 is 50 microns, and the thickness of the first electron transport layer 306 is 100 microns. The thickness of the first electron generation sub-layer 2021 is 110 microns, and the thickness of the first hole generation sub-layer 2022 is 80 microns. The thickness of the second hole transport layer 307 is 200 microns, the thickness of the second electron blocking layer 308 corresponding to the blue sub-pixel is 50 microns, the thickness of the second electron blocking layer 308 corresponding to the green sub-pixel is 60 microns, the thickness of the second electron blocking layer 308 corresponding to the red sub-pixel is 120 microns, and the thickness of the second organic light emitting layer 309 corresponding to the blue sub-pixel is 150 microns. The thickness of the second organic light emitting layer 309 corresponding to the green sub-pixel is 300 microns, the thickness of the second organic light emitting layer 309 corresponding to the red sub-pixel is 400 microns, the thickness of the second hole blocking layer 310 is 50 microns, and the thickness of the second electron transport layer 311 is 90 microns. The thickness of the second electron generation sub-layer 2041 is 105 microns, and the thickness of the second hole generation sub-layer 2042 is 80 microns. The thickness of the third hole transport layer 312 is 200 microns, the thickness of the third electron blocking layer 313 corresponding to the blue sub-pixel is 50 microns, the thickness of the third electron blocking layer 313 corresponding to the green sub-pixel is 60 microns, and the thickness of the third electron blocking layer 313 corresponding to the red sub-pixel is 120 microns. The thickness of the third organic light emitting layer 314 corresponding to the blue sub-pixel is 150 microns, the thickness of the third organic light emitting layer 314 corresponding to the green sub-pixel is 300 microns, the thickness of the third organic light emitting layer 314 corresponding to the red sub-pixel is 400 microns, the thickness of the third hole blocking layer 315 is 50 microns, and the thickness of the third electron transport layer 316 is 100 microns.

The display effects of the display panels formed by the display substrates in the above first embodiment to the sixth embodiment and first comparative example were tested, and the following Table 1 was obtained.

**Table 1: Display effects of display panels formed by display substrates in the first embodiment to the sixth embodiment and first comparative example.**

| | | Service life | | | | | Power consumption | EL red light accompanying intensity |
|---|---|---|---|---|---|---|---|---|
| Display panel | color | voltage/ V | Cd/A | CIEx | CIEy | LT95@1000nit | | |
| First embodiment | B | 8.4 | 19 | 0.138 | 0.040 | 1940 | 6200mW | 0.8% |
| | G | 8.6 | 550 | 0.250 | 0.681 | 1850 | | 0.4% |
| | R | 7.8 | 190 | 0.685 | 0.313 | 2460 | | - |
| Second embodiment | B | 8.3 | 18 | 0.138 | 0.038 | 1980 | 6180mW | 0.2% |
| | G | 8.5 | 535 | 0.251 | 0.680 | 1750 | | 0.1% |
| | R | 8.0 | 182 | 0.684 | 0.310 | 2560 | | - |
| Third embodiment | B | 8.0 | 18.6 | 0.140 | 0.039 | 2010 | 6106mW | 0.6% |
| | G | 8.3 | 565 | 0.250 | 0.685 | 1860 | | 0.5% |
| | R | 7.6 | 189 | 0.690 | 0.312 | 2660 | | - |
| Fourth embodiment | B | 8.2 | 17.6 | 0.138 | 0.039 | 1850 | 6206mW | 0.4% |
| | G | 8.1 | 538 | 0.254 | 0.680 | 1950 | | 0.3% |
| | R | 7.5 | 175 | 0.688 | 0.310 | 2460 | | - |
| Fifth embodiment | B | 8.0 | 19.2 | 0.138 | 0.041 | 1880 | 6006mW | 0.6% |
| | G | 8.3 | 565 | 0.245 | 0.680 | 1850 | | 0.5% |
| | R | 8.1 | 177 | 0.686 | 0.310 | 2320 | | - |
| Sixth embodiment | B | 8.3 | 16.8 | 0.138 | 0.038 | 2020 | 6125mW | 0.7% |
| | G | 8.5 | 522 | 0.251 | 0.680 | 1950 | | 0.6% |
| | R | 8.1 | 170 | 0.684 | 0.310 | 2760 | | - |
| First comparative example | B | 8.8 | 13.2 | 0.138 | 0.044 | 1680 | 7106mW | 6.2% |
| | G | 8.6 | 489 | 0.258 | 0.680 | 1550 | | 4.8% |
| | R | 8.3 | 142 | 0.678 | 0.310 | 1890 | | - |

It can be seen from Table 1 above, the service life of the display panel formed by using the display substrates in first embodiment to the sixth embodiment of the present disclosure is obviously longer than that of the display panel formed in first comparative example, and the power consumption of the display panel formed by using the display substrates in first embodiment to the sixth embodiment of the present disclosure is obviously lower than that of the display panel formed in first comparative example. In addition, the EL red light accompanying intensity of the display panel formed by using the display substrates in first embodiment to the sixth embodiment of the present disclosure is obviously smaller than that of the display panel formed by the display substrate in first comparative example.

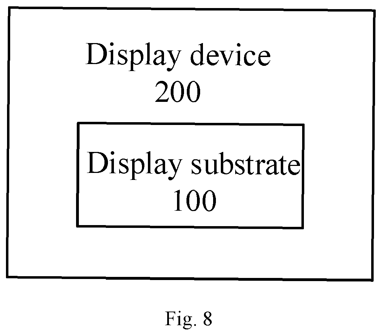

At least one embodiment of the present disclosure also provides a display device, which includes the display substrate described in any one of the above. Fig. 8 is a schematic diagram of a display device provided by an embodiment of the present disclosure. As illustrated by Fig. 8, the display device 200 includes the display substrate 100. According to the display substrate, the partition structure is arranged between adjacent sub-pixels, and the charge generation layer in the light emitting functional layer is disconnected at the position where the partition structure is located, so that crosstalk between adjacent sub-pixels caused by the charge generation layer with higher conductivity is avoided. Therefore, the display device including the display substrate can also avoid crosstalk between adjacent sub-pixels, thus having higher product yield and higher display quality.

Because the display substrate provided by the embodiment of the present disclosure adopts the double-layer light emitting design, the pixels per inch is improved. Therefore, the display device including the display substrate also has the advantages of long service life, low power consumption, high brightness and high resolution.

For example, the display device can be a display device such as an organic light emitting diode display device, and any product or component with display function including the display device such as a TV, a digital camera, a mobile phone, a watch, a tablet computer, a notebook computer, a navigator, etc. This embodiment is not limited thereto.

The following points need to be explained:
(1) The drawings of the embodiment of the present disclosure only relate to the structure related to the embodiment of the present disclosure, and other structures can refer to the general design.
(2) For the sake of clarity, in the drawings used to describe the embodiments of the present disclosure, the thickness of layers or regions is enlarged or reduced, that is, these drawings are not drawn to actual scale.
(3) In the case of no conflict, the embodiments of the present disclosure and the features in the embodiments can be combined with each other to obtain a new embodiment.

The above is only the specific implementation of the present disclosure, but the scope of protection of the present disclosure is not limited thereto, and the scope of protection of the present disclosure should be subject to the scope of protection of the claims.

## Claims

1. A display substrate, comprising:
a base substrate;
a pixel defining layer, located on the base substrate and comprising a plurality of pixel openings and a pixel spacing portion;
a plurality of sub-pixels, located on the base substrate and arranged in one-to-one correspondence with the plurality of pixel openings, wherein each of the plurality of sub-pixels comprises a light emitting element, the light emitting element comprises a light emitting functional layer and a second electrode and a first electrode located on two sides of the light emitting functional layer in a direction perpendicular to a main surface of the base substrate, and the first electrode is located between the light emitting functional layer and the base substrate; and
a partition structure, located between adjacent sub-pixels of the plurality of sub-pixels and at a side of the pixel spacing portion away from the base substrate,
wherein the light emitting functional layer comprises a first organic light emitting functional layer, a first charge generation layer, a second organic light emitting functional layer, a second charge generation layer and a third organic light emitting functional layer which are at least partially stacked on the pixel spacing portion in the direction perpendicular to the main surface of the base substrate, and a distance between a surface, which is farthest from the pixel defining layer, of a portion of the second charge generation layer located on the pixel spacing portion and the pixel defining layer is smaller than a height of the partition structure in the direction perpendicular to the main surface of the base substrate.

2. The display substrate according to claim 1, wherein the second charge generation layer comprises a second electron generation sub-layer and a second hole generation sub-layer which are stacked, and a distance between a surface, which is farthest from the pixel defining layer, of a portion of the second hole generation sub-layer and the pixel defining layer is smaller than the height of the partition structure in the direction perpendicular to the main surface of the base substrate.

3. The display substrate according to claim 2, wherein the distance between the surface, which is farthest from the pixel defining layer, of the portion of the second hole generation sub-layer and the pixel defining layer is L1, the height of the partition structure in the direction perpendicular to the main surface of the base substrate is L2, L1 is greater than or equal to 0.12µm and less than or equal to 0.14µm, and L2 is greater than or equal to 0.42µm and less than or equal to 1.45µm.

4. The display substrate according to claim 2, wherein,
the first organic light emitting functional layer comprises a hole injection layer, a first hole transport layer, a first electron blocking layer, a first organic light emitting layer, a first hole blocking layer and a first electron transport layer which are stacked;
the first charge generation layer comprises a first electron generation sub-layer and a first hole generation sub-layer which are stacked;
the second organic light emitting functional layer comprises a second hole transport layer, a second electron blocking layer, a second organic light emitting layer, a second hole blocking layer and a second electron transport layer;
the third organic light emitting functional layer comprises a third hole transport layer, a third electron blocking layer, a third organic light emitting layer, a third hole blocking layer and a third electron transport layer which are stacked;
the hole injection layer, the first hole transport layer and the first electron blocking layer constitute a first organic functional layer;
the first hole blocking layer, the first electron transport layer, the first electron generation sub-layer, the first hole generation sub-layer, the second hole transport layer and the second electron blocking layer constitute a second organic functional layer;
the second hole blocking layer, the second electron transport layer, the second electron generation sub-layer, the second hole generation sub-layer, the third electron blocking layer and the third electron transport layer constitute a third organic functional layer;
the third hole blocking layer and the third electron transport layer constitute a fourth organic functional layer.

5. The display substrate according to claim 4, wherein a relationship between a thickness L3 of the second organic functional layer and a thickness L4 of the first organic functional layer is: L3 > L4.

6. The display substrate according to claim 5, wherein a relationship between a thickness L5 of the third organic functional layer and a thickness L6 of the fourth organic functional layer is: L5 > L6.

7. The display substrate according to claim 6, wherein the thickness L3 of the second organic functional layer is less than or equal to the thickness L5 of the third organic functional layer.

8. The display substrate according to any one of claims 1 to 7, wherein the sub-pixel is a red sub-pixel, and a thickness of the first organic light emitting layer, a thickness of the second organic light emitting layer, and a thickness of the third organic light emitting layer in the red sub-pixel are all greater than a thickness of a thickest one of sub-layers in the first organic functional layer, and are all greater than a thickness of a thickest one of sub-layers in the third organic functional layer.

9. The display substrate according to any one of claims 1 to 7, wherein the sub-pixel is a blue sub-pixel, and a thickness of the first organic light emitting layer, a thickness of the second organic light emitting layer, and a thickness of the third organic light emitting layer in the blue sub-pixel are all smaller than a thickness of a thickest one of sub-layers in the first organic functional layer, and are all smaller than a thickness of a thickest one of sub-layers in the third organic functional layer.

10. The display substrate according to any one of claims 1 to 9, wherein the plurality of pixel openings respectively define effective light emitting regions of the plurality of sub-pixels, and each of the plurality of pixel openings is configured to expose the first electrode.

11. A display device, comprising the display substrate according to any one of claims 1 to 10.
